# EUROPEAN PATENT APPLICATION

(11) **EP 3 751 600 A1**
(43) Date of publication of application: **16.12.2020**
(21) Application number: 18904630.3
(22) Date of filing: 08.08.2018
(51) Int. Cl.: H01L 23/29, H01L 23/00, H01L 23/31, H01L 25/07, H01L 25/18

(54) **SEMICONDUCTOR DEVICE**

(30) Priority: 07.02.2018 JP 2018020222
(71) Applicant: KABUSHIKI KAISHA TOSHIBA, Minato-ku Tokyo 105-0023 (JP); Toshiba Energy Systems & Solutions Corporation, Saiwai-ku Kawasaki-shi Kanagawa 2120013 (JP)
(72) Inventor: ITO, Hiroaki, Tokyo 105-0023 (JP); ICHIKURA, Yuta, Tokyo 105-0023 (JP); WATANABE, Naotake, Tokyo 105-0023 (JP); TADA, Nobumitsu, Tokyo 105-0023 (JP); HIRATSUKA, Daisuke, Tokyo 105-0023 (JP); TASHIRO, Shota, Tokyo 105-0023 (JP); MIZUTANI, Mami, Tokyo 105-0023 (JP); SEKIYA, Hiroki, Kawasaki-shi, Kanagawa 212-0013 (JP); HISAZATO, Yuuji, Kawasaki-shi, Kanagawa 212-0013 (JP); IIO, Naotaka, Kawasaki-shi, Kanagawa 212-0013 (JP); MATSUMURA, Hitoshi, Tokyo 105-0023 (JP)
(74) Representative: Moreland, David
(86) International application number: PCT/JP2018/029723
(87) International publication number: WO 2019/155659

(57) **Abstract**

A semiconductor device (1) includes a plurality of semiconductor element parts (SM1) connected in parallel. The semiconductor element parts (SM1) include a first metal member (30), a second metal member (20) opposite to the first metal member (20), at least one semiconductor element (40) provided between the first metal member (30) and the second metal member (20), a resin member (70) sealing the semiconductor element (40) between the first metal member (30) and the second metal member (20), and a reinforcement member (50) provided to surround the first metal member (30) and the second metal member (20). The reinforcement member (50) has higher strength than the strength of the resin member (70).

## Description

### [Technical Field]

Embodiments relate to a semiconductor device.

### [Technical Background]

There is a semiconductor device in which a large current of several kiloamperes (kA) can be switched by multiple semiconductor elements connected in parallel. Further, a power conversion device can be configured to operate under a high voltage of several kilovolts (kV) with the multiple semiconductor devices connected in series. In such a power conversion device, when a short circuit failure occurs in one of the semiconductor devices connected in series, it is preferable to continuously operate by other semiconductor devices. Such a redundancy may be achieved by an explosion-proof structure which can prevent explosive breakage when the semiconductor device is short-circuited, however, it is difficult to achieve such a structure with low cost and without inhibiting the downsizing of the power conversion device.

### [Prior Art]

### [Patent Document]

[Patent Document 1] Japanese Patent No. 3258200
[Patent Document 2] Japanese Patent No. 4385324

### [Summary of Invention]

### [Problem to be Solved]

The embodiments provide a semiconductor device having an explosion-proof structure achieved with low cost and capable of downsizing.

### [Means for Solving Problem]

According to one embodiment, a semiconductor device includes a plurality of semiconductor-element parts connected in parallel. The semiconductor-element parts include a first metal member, a second metal member facing the first metal member, at least one semiconductor element arranged between the first metal member and the second metal member, a resin member sealing the semiconductor element between the first metal member and the second metal member, and a reinforcement member provided to surround the first metal member and the second metal member. The reinforcement member has higher strength than the strength of the resin member.

### [Brief Description of Drawings]

FIG. 1 is a schematic cross-sectional view showing a semiconductor device according to a first embodiment.
FIG. 2 is a perspective view schematically showing a semiconductor element module according to the first embodiment.
FIG. 3 is a schematic cross-sectional view showing the semiconductor element module according to the first embodiment.
FIG. 4 is another schematic cross-sectional view showing the semiconductor element module according to the first embodiment.
FIG. 5 is a schematic cross-sectional view showing a semiconductor device according to a second embodiment.
FIG. 6 is a perspective view schematically showing a semiconductor element module according to the second embodiment.
FIG. 7 is a schematic cross-sectional view showing a semiconductor element module according to a third embodiment.
FIG. 8 is another schematic cross-sectional view showing the semiconductor element module according to the third embodiment.
FIG. 9 is a schematic cross-sectional view showing a semiconductor element module according to a comparative example.

### [Embodiments of Invention]

Embodiments of the invention will be described with reference to the drawings. Similar portions on the drawing are marked with the same numeral and detailed description will be appropriately omitted, and different portions will be described. The drawings are schematic and conceptual; and the relationships between the thickness and width of portions, the proportions of sizes among portions, etc., are not necessarily the same as the actual values. The dimensions and proportions even for identical portions may be illustrated differently among drawings.

Furthermore, the arrangement and configuration of each portion will be described using the X-axis, Y-axis, and Z-axis shown in each drawing. The X-axis, the Y-axis, and the Z-axis are orthogonal to each other and represent the X-direction, the Y-direction, and the Z-direction, respectively. Further, the Z-direction may be described as an upward and the direction opposite thereto may be described as downward.

### (First embodiment)

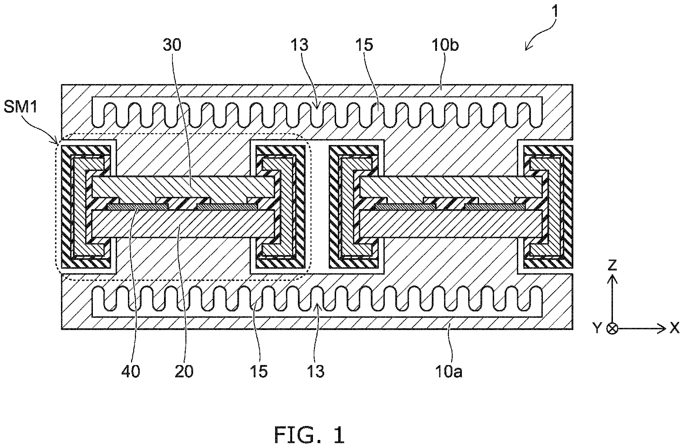

FIG. 1 is a schematic cross-sectional view showing a semiconductor device 1 according to the first embodiment. The semiconductor device 1 includes multiple semiconductor element modules SM1, a cooling member 10a and a cooling member 10b. The semiconductor element modules SM1 are provided between the cooling members 10a and 10b. The semiconductor element modules SM1 are connected in parallel to the cooling members 10a and 10b each serving as a common electrode.

The cooling members 10a and 10b each include a space 13, and include cooling fins 15 protruding inside the space 13. For example, a cooling liquid such as deionized water is circulated inside the space 13 to cause heat dissipation from a semiconductor element module SM1.

The semiconductor element module SM1 includes a metal member 20, a metal member 30 and at least one semiconductor element 40. The semiconductor element 40 is provided between the metal member 20 and the metal member 30.

The semiconductor element 40 is, for example, a transistor element such as an IGBT (Insulated Gate Bipolar Transistor) and a MOSFET (Metal-Oxide-Semiconductor Field Effect Transistor), or a diode element such as an FRD (Fast Recovery Diode). One semiconductor element module SM1 may include both the transistor element and the diode element. The metal member 20 and the metal member 30 include, for example, copper or aluminum as a main component.

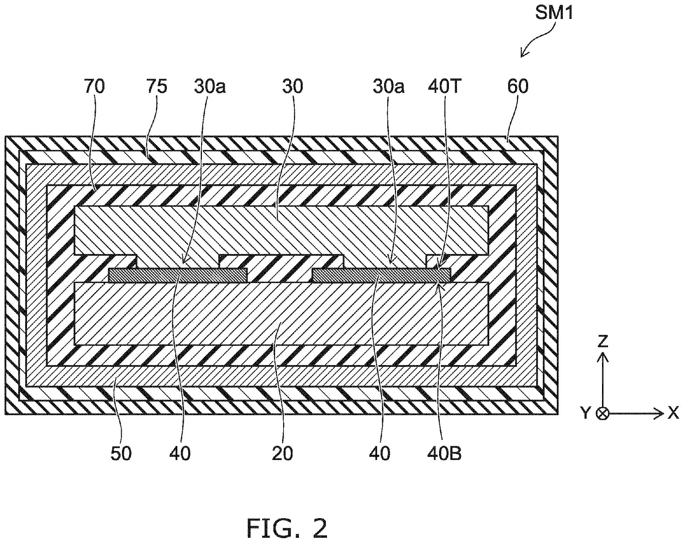

FIG. 2 is a schematic view showing a cross section of the semiconductor element module SM1. The semiconductor element module SM1 further includes a reinforcement member 50, a case 60 and resin members 70 and 75.

The reinforcement member 50 is provided to surround the metal members 20 and 30. The reinforcement member 50 is, for example, a metal member. The case 60 is made of, for example, a resin member. The metal members 20, 30, the semiconductor element 40 and the reinforcement member 50 are housed in the case 60. A ceramic material may also be used for the reinforcement member 50. In such a case, the case 60 may be omitted.

As shown in FIG. 2, the metal member 30 has a protruding portion 30a at the lower surface thereof. The semiconductor element 40 is provided between the metal member 20 and the protruding portion 30a. The protruding portion 30a may be provided integrally with the metal member 30, or may be a conductive member attached to the lower surface of the metal member 30. The protruding portions 30a are provided at the lower surface of the metal member 30 with the same number as the number of the semiconductor elements 40.

A first electrode (not shown) is provided on a surface 40T of the semiconductor element 40. The first electrode is, for example, an emitter electrode, a source electrode or a cathode electrode. The first electrode is connected to the protruding portion 30a by a conductive bonding material (not shown). The protrusion 30a has a shape that fits, for example, the first electrode when viewed in the Z-direction.

On the other hand, a second electrode (not shown) is provided on a back surface 40B of the semiconductor element 40. The second electrode is, for example, a collector electrode, a drain electrode or an anode electrode. The second electrode is connected to the metal member 20 via a conductive bonding material (not shown).

The resin member 70 is provided to fill the internal space of the reinforcement member 50. The resin member 70 includes a portion sealing the semiconductor element 40 between the metal member 20 and the metal member 30. The resin member 70 includes other portions provided between the metal member 20 and the reinforcement member 50 and between the metal member 30 and the reinforcement member 50.

The resin member 75 is provided between the reinforcement member 50 and the case 60. The resin members 70 and 75 are, for example, thermosetting resins such as an epoxy resin. The resin members 70 and 75 are formed by vacuum molding.

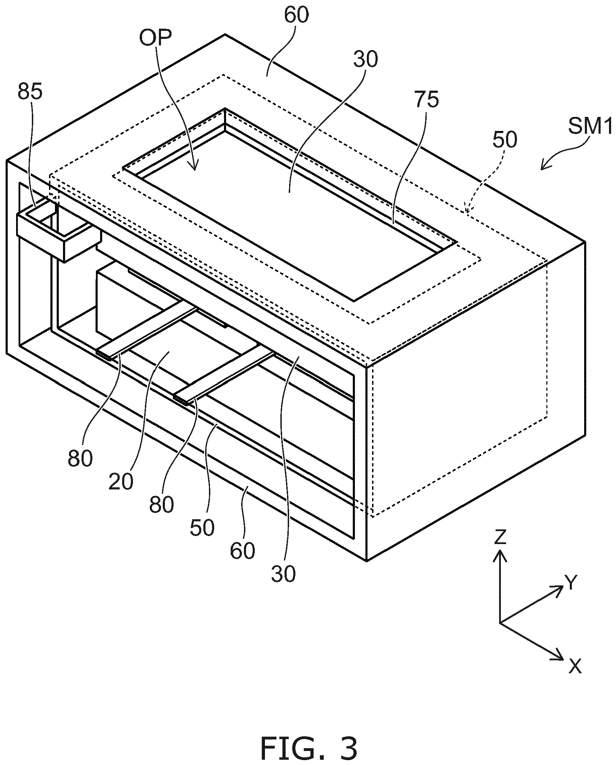

FIG. 3 is a perspective view schematically showing the semiconductor element module SM1 according to the first embodiment. In FIG. 3, the resin member 70 is omitted to show the structure of the semiconductor element module SM1.

As shown in FIG. 3, the semiconductor element module SM1 has an opening OP at the upper surface thereof in which the metal member 30 is partially exposed. The reinforcement member 50 and the case 60 each have an opening corresponding to the opening OP. Moreover, the semiconductor element module SM1 also has an opening OP at the lower surface (not shown) in which the metal member 20 is partially exposed. The metal members 20 and 30 are connected to the cooling members 10a and 10b through the openings OP (see FIG. 1).

The semiconductor element module SM1 further includes a gate terminal 80 and a connection conductor 85. The gate terminal 80 is connected to the gate electrode of the semiconductor element 40. The gate terminal 80 extends toward the outside of the space between the metal member 20 and the metal member 30. The reinforcement member 50 and the case 60 have, for example, a shape of substantially rectangular parallelepiped box that has an opening in the extending direction of the gate terminal 80. The connection conductor 85 electrically connects the metal member 30 and the reinforcement member 50, for example. Thereby, the reinforcement member 50 has the same potential as a potential of the metal member 30. When the reinforcement member 50 is an insulator such as a ceramic member, the connecting conductor 85 is not provided.

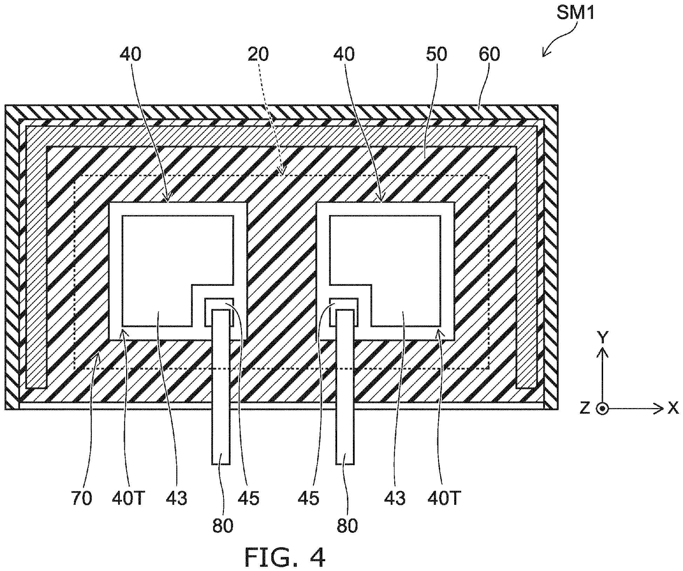

FIG. 4 is a schematic view showing other cross-section of the semiconductor element module SM1 of the first embodiment. FIG. 4 is a cross-sectional view showing the semiconductor element 40 provided on the metal member 20. The semiconductor element 40 is, for example, a transistor element. The semiconductor element 40 has a gate electrode 45.

As shown in FIG. 4, two semiconductor elements 40 are provided on the metal member 20. The semiconductor element 40 includes an emitter electrode 43 (or a source electrode) and the gate electrode 45 provided on the surface 40T thereof. The gate terminal 80 is connected to the gate electrode 45. The gate terminal 80 extends toward the outside of the semiconductor element module SM1 from the resin member 70. The gate terminal 80 is made of, for example, a metal material including copper or aluminum as a main component. The gate terminal 80 is connected to a control circuit (not shown).

The metal members 20, 30 and the semiconductor element 40 are housed inside the reinforcement member 50 that has, for example, the box-like shape having an opening at one side thereof. The case 60 that covers the reinforcement member 50 also has a box-like shape that has an opening at one side thereof. The gate terminal 80 extends toward the outside through the openings of the reinforcement member 50 and the case 60.

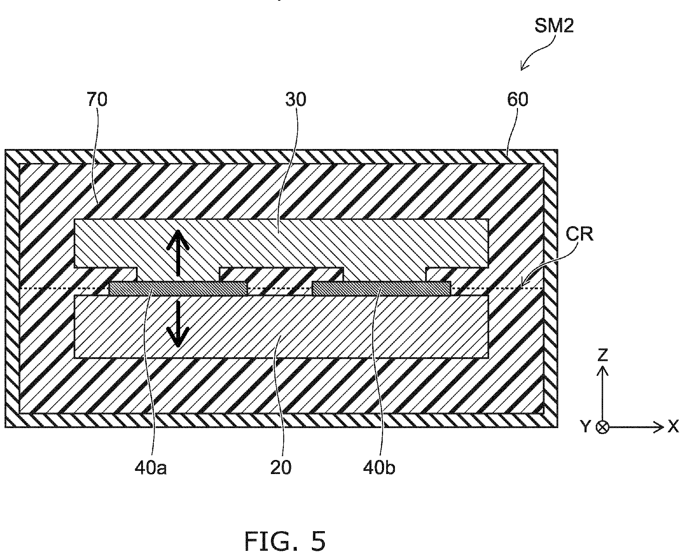

FIG. 5 is a schematic cross-sectional view showing a semiconductor element module SM2 according to a comparative example. The semiconductor element module SM2 includes metal members 20 and 30 and semiconductor elements 40a and 40b which are housed in the case 60. The semiconductor elements 40a and 40b are arranged between the metal member 20 and the metal member 30. The resin member 70 is filled in the case 60, and the semiconductor elements 40a and 40b are sealed between the metal member 20 and the metal member 30. Further, as shown in FIG. 5, the semiconductor element module SM2 does not include the reinforcement member 50.

For example, when a short circuit failure occurs in one of the semiconductor elements 40, the electrical conduction is provided between the metal member 20 and the metal member 30. For example, when the semiconductor element 40a includes the short circuit failure and other semiconductor element 40b is normally turned off, the current flowing through the semiconductor element module SM2 is concentrated in the semiconductor element 40a. Moreover, because the conduction resistance in the semiconductor element 40a is lower than the conduction resistance (i.e., the channel resistance) in the other semiconductor element 40b that normally operates, the current flowing through the semiconductor element module SM2 is concentrated in the semiconductor element 40a. In any case, an excess-current flows through the semiconductor element 40a, resulting in melting or vaporizing by Joule heat at, for example, the bonding member provided between the semiconductor element 40a and the metal member 20 or 30, and a portion of the semiconductor element 40a. Thereby, the internal pressure is raised in the resin member 70 that seals the semiconductor element 40a.

Thus, the resin member 70 is broken by the pressure acting upward and downward so as to let the metal members 20 and 30 apart from each other, for example, making a crack CR extend in the lateral direction. The crack CR may reach the case 60, and then, the pressure acts on the case 60. If the case 60 has the strength not enough to withstand the pressure, the semiconductor element module SM2 may be broken explosively.

In contrast, the semiconductor element module SM1 according to the embodiment has the reinforcement member 50 that surrounds the metal members 20 and 30. A material having higher strength than the strengths of the case 60 and the resin member 70 is used for the reinforcement member 50. Here, the strength is defined as the tensile load applied at the time of the material breakage and divided by the cross-sectional area of the material (e.g., the initial cross-sectional area or the cross-sectional area at the breakage). Alternatively, the tensile strength or compressive strength of the material may be used. For example, metal or ceramic which has higher strength than the strength of the resin member may be used as the material of the reinforcement member 50.

Further, the reinforcement member 50 is desired to have toughness higher than the resin member. Having high toughness means both the large strength (tensile strength) and large ductility, and such a material having high toughness may be metal. The reinforcement member 50 includes, for example, iron, stainless steel or aluminum as a main component.

For example, when the metal member is used for the reinforcement member 50, the toughness thereof is higher than that of the case 60. The reinforcement member 50 has the large ductility. Therefore, the reinforcement member 50 receives the internal pressure and deformed such as extending upward and downward from the crack CR serving as origin. That is, it is possible for the reinforcement member 50 not to be broken, and to be flexibly deformed, owing to the ductility thereof. Thus, the crack CR is prevented from reaching the case 60, and thereby, it is possible to reduce the force applied to the resin member 75 and the case 60 that cover the outside of the reinforcement member 50.

Further, by using the reinforcement member 50 with the box shape, it is possible to suppress the displacement and the deformation of the metal member 20 and the metal member 30 when the displacement and the deformation is going to take place so that the metal member 20 and the metal member 30 are separated downward and upward from each other.

In the case where the ceramic material having the large breaking strength is used for the reinforcement member 50, the deformation and breakage due to the internal pressure do not occur when the crack CR reaches the reinforcement member 50, and thus, it is possible to prevent the resin member 70 from the separation. Also, the separation of the metal member 20 and the metal member 30 housed can be suppressed inside the reinforcement member 50 having the box-like shape.

As described above, the material capable of withstanding the internal pressure in the resin member 70 at the time of failure is used for the reinforcement member 50. It is possible to avoid the explosive breakage due to the short-circuit failure in the semiconductor element 40.

The reinforcement member 50 may be provided to have a portion contacting the inner surface of the case 60. That is, the resin member 75 provided between the reinforcement member 50 and the case 60 may be omitted. The reinforcement member 50 is provided to be, for example, movable with respect to the case 60. Thereby, it is possible to prevent the case 60 from the stress applied due to the deformation of the reinforcement member 50. That is, even if the reinforcement member 50 is in contact with the inner surface of the case 60, it is possible to absorb the stress applied to the case 60 by the reinforcement member 50 that has a structure capable of being deformed along the inner surface of the case 60.

Further, when the resin member 70 and the resin member 75 completely seal the reinforcement member 50 to ensure the electrical insulation, the resin member 75 at the outside may provide the outermost periphery and make it possible to omit the case 60.

Such an explosion-proof structure is simplified comparing with the explosion-proof structure that covers the entire semiconductor device 1, and can be achieved with low cost. It also contributes to the downsizing of the semiconductor device 1.

In the above example, the connection conductor 85 electrically connecting the metal member 30 and the reinforcement member 50 is shown, but the embodiment is not limited thereto. The metal member 20 and the reinforcement member 50 may be provided to be electrically connected to each other. That is, the reinforcement member 50 may have the same potential as the potential of any one of the metal members 20 and 30.

### (Second embodiment)

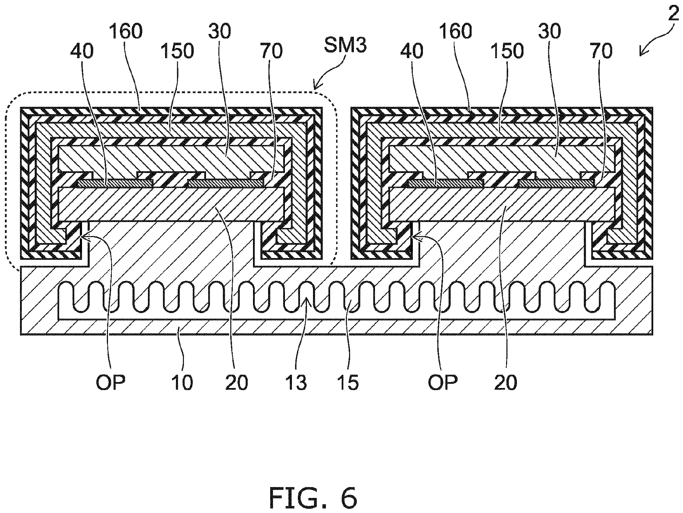

FIG. 6 is a schematic cross-sectional view showing a semiconductor device 2 according to the second embodiment. The semiconductor device 2 includes multiple semiconductor element modules SM3 arranged on the cooling member 10.

The semiconductor element module SM3 includes the metal member 20, the metal member 30, the semiconductor element 40, a reinforcement member 150 and a case 160. The semiconductor element 40 is provided between the metal members 20 and 30. The semiconductor element 40 is sealed by the resin member 70. The reinforcement member 150 is provided to surround the metal members 20 and 30. The metal members 20, 30, the semiconductor element 40 and the reinforcement member 150 are housed in the case 160. The reinforcement member 150 is, for example, a metal member or a ceramic member, and the case 160 is an insulating material such as a resin member.

The reinforcement member 150 and the case 160 are each provided to have a box shape having an opening OP at the lower surface. The metal member 20 has a portion of the lower surface exposed at the opening OP. The cooling member 10 includes a convex portion connected to the metal member 20 through the opening OP.

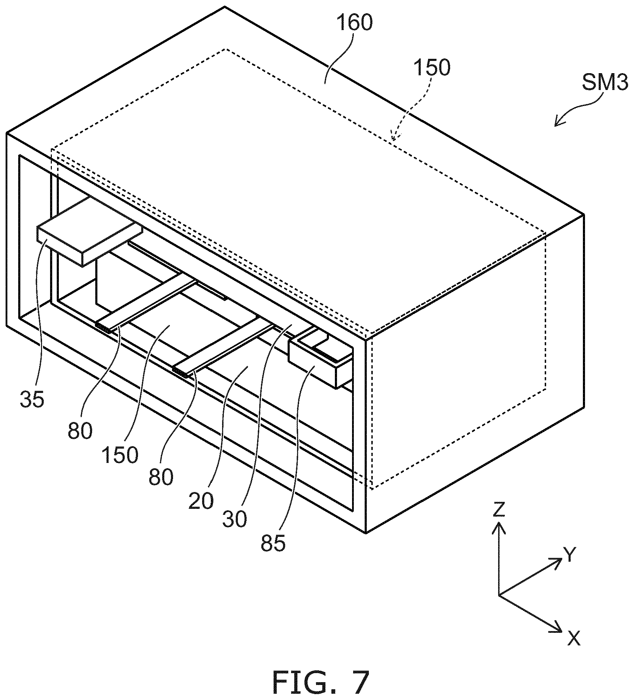

FIG. 7 is a perspective view schematically showing the semiconductor element module SM3. The reinforcement member 150 and the case 160 each have a box shape having an opening at one surface side. Note that, in FIG. 7, the resin member provided inside the semiconductor element module SM3 is omitted to show the structure thereof.

The reinforcement member 150 has a lower surface and an upper surface facing the metal members 20 and 30, respectively. The reinforcement member 150 has an opening at the lower surface (not shown), which corresponds to the opening OP. The case 160 has an opening portion in which the side surfaces of the metal members 20 and 30 are exposed. The case 160 has an opening on the lower surface thereof, which corresponds to the opening OP.

As shown in FIG. 7, the semiconductor element module SM3 further includes an interconnection terminal 35, the gate terminal 80, and the connection conductor 85. The interconnection terminal 35 is connected to the metal member 30. The interconnection terminal 35 extends toward the outside through the respective opening portions of the reinforcement member 150 and the case 160. The multiple semiconductor element modules SM3 (see FIG. 6) arranged on the cooling member 10 are connected in parallel by providing, for example, an interconnection plate or a bus bar (not shown) connected to the interconnection terminal 35.

The gate terminal 80 is connected to the gate electrode 45 of the semiconductor element 40, and extends toward the outside through each opening portion of the reinforcement member 150 and the case 160. The gate terminal 80 is electrically connected to, for example, a control circuit (not shown). The connection conductor 85 is provided to electrically connect the metal member 30 and the reinforcement member 150, for example.

In the semiconductor device 2, for example, the device structure may be simplified by omitting one of the cooling members 10a and 10b (see FIG. 1) that is connected to the semiconductor element module SM1. Although the cooling member 10 provided at the lower surface side of the semiconductor element module SM3 is shown in the above example, the embodiment is not limited thereto. That is, the cooling member 10 may be provided at the upper surface side of the semiconductor element module SM3.

Moreover, when the cooling member 10 is not necessarily connected directly to the semiconductor element module SM3, the opening OP may be omitted, which are provided in the reinforcement member 150 and the case 160. In such a case, the interconnect terminal 35 is connected to each of the metal members 20 and 30, and multiple semiconductor element modules SM3 are connected in parallel by an interconnection plate (not shown) connected to the interconnection terminal 35.

In the embodiment, by providing the reinforcement member 150, it is possible to prevent explosive damage when the short circuit failure occurs in the semiconductor element module SM3. Such an explosion-proof structure can be achieved with at low cost, and also contributes to the downsizing of the semiconductor device 2.

### (Third embodiment)

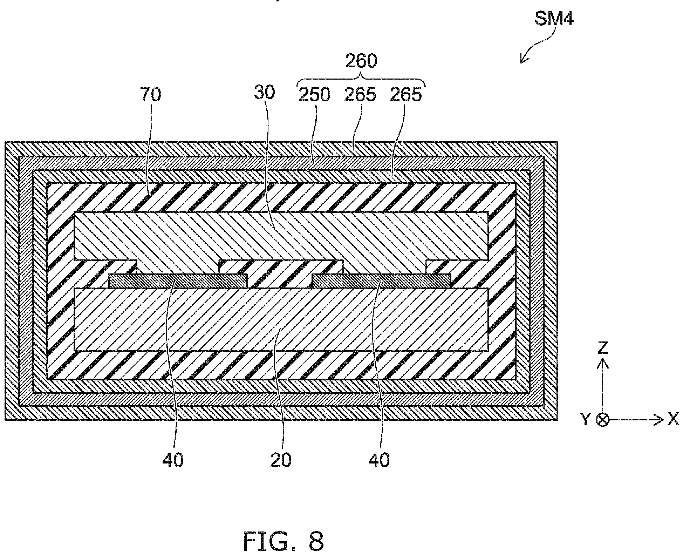

FIG. 8 is a schematic cross-sectional view showing a semiconductor element module SM4 according to the third embodiment. The semiconductor element module SM4 includes metal members 20 and 30, the semiconductor element 40, and a case 260. The case 260 includes a reinforcement member 250 and a resin member 265.

The semiconductor element 40 is provided between the metal members 20 and 30, and is placed inside the case 260 together with the metal members 20 and 30. The case 260 is filled with the resin member 70, and the semiconductor element 40 is sealed inside the metal members 20 and 30. The reinforcement member 250 is provided to surround the metal members 20 and 30.

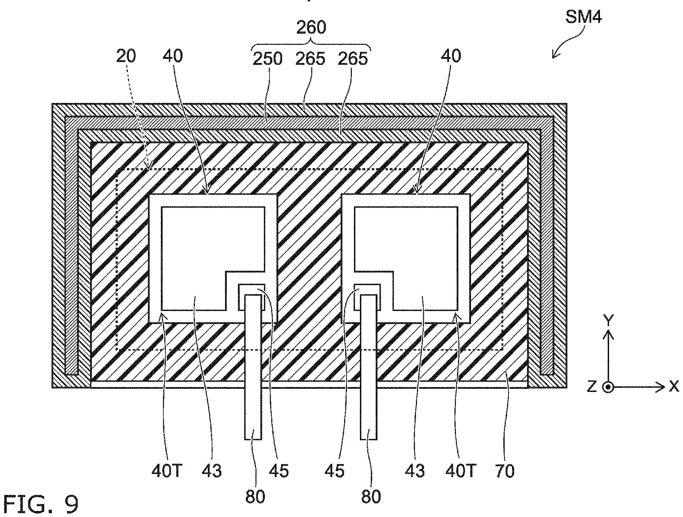

FIG. 9 is another schematic cross-sectional view showing the semiconductor element module SM4. FIG. 9 is a schematic view showing the semiconductor element 40 provided on the metal member 20.

The semiconductor element 40 includes the emitter electrode 43 (or the source electrode) and the gate electrode 45, which are provided on the surface 40T. The case 260 has a box shape having an opening at one surface side, and includes a reinforcement member 250 provided to face three side surfaces in each of the metal members 20 and 30. The gate terminal 80 connected to the gate electrode 45 extends toward the outside through the opening portion of the case 260.

In the embodiment, the case 260 includes the reinforcement member 250, which prevents the explosive breakage when the short circuit failure occurs in the semiconductor element module SM4. Moreover, by providing the reinforcement member 250 integrally with the case 260 inside the thereof, it is possible in the semiconductor element module SM4 to reduce the number of parts and to improve the manufacturing efficiency.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A semiconductor device (1), comprising:
a plurality of semiconductor element parts (SM1) connected in parallel, the semiconductor element parts (SM1) including:
a first metal member (30);
a second metal member (20) opposite to the first metal member (30);
at least one semiconductor element (40) provided between the first metal member (30) and the second metal member (20);
a resin member (70) sealing the semiconductor element (40) between the first metal member (30) and the second metal member (20); and
a reinforcement member (50) provided to surround the first metal member (30) and the second metal member (20), the reinforcement member (50) having a higher strength than a strength of the resin member (70).

2. The semiconductor device (1) according to claim 1, wherein the reinforcement member (50) includes metal.

3. The semiconductor device (1) according to claim 2, further comprising:
another resin member (75) covering the reinforcement member (50).

4. The semiconductor device (1) according to claim 2, wherein
the reinforcement member (50) is electrically connected to one of the first metal member (30) and the second metal member (20).

5. The semiconductor device (1) according to claim 1, wherein the reinforcement member (50) includes ceramic.

6. The semiconductor device (1) according to claim 1, further comprising:
a lead (80) connected to the semiconductor element (40), the lead (80) extending toward the outside of a space between the first metal member (30) and the second metal member (20),
the reinforcement member (50) having an opening portion at a side in an extending direction of the lead (80).

7. The semiconductor device (1) according to claim 1, wherein
the reinforcement member (50) has an opening (OP), one of the first metal member (30) or the second metal member (20) being partially exposed at the opening (OP).

8. The semiconductor device (1) according to claim 1, wherein
the semiconductor element (40) includes a first electrode (43) and a second electrode opposite to the first electrode,
the first metal member (30) is connected to the first electrode (43), and
the second metal member (30) is connected to the second electrode.

9. The semiconductor device (1) according to claim 8, wherein
the first metal member (30) has a convex portion (30a) connected to the first electrode (43).

10. The semiconductor device (1) according to claim 1, wherein
the resin member (70) includes first and second portions, the space between the first metal member (30) and the second metal member (20) being filled with the first portion, the spaces between the reinforcement member (50) and the first metal member (20) and between the reinforcement member (50) and the first metal member (20) being filled with the second portion.
